# EUROPEAN PATENT SPECIFICATION

(11) **EP 2 285 200 B1**
(45) Date of publication and mention of the grant of the patent: **29.05.2013**
(21) Application number: 09178081.7
(22) Date of filing: 04.12.2009
(51) Int. Cl.: H05K 9/00

(54) **One-piece shielding hood with one or more pins**
Einteilige Abschirmhaube mit einem oder mehreren Stiften
Hotte de protection d'un seul tenant avec une ou plusieurs broches

(30) Priority: 07.08.2009 EP 09167502
(43) Date of publication of application: 16.02.2011
(73) Proprietor: Cinterion Wireless Modules GmbH, 81541 München (DE)
(72) Inventor: Horn, Annette, 13469 Berlin (DE); Romahn, Jörg, 12353 Berlin (DE); Wendler, Ralf, 14612 Falkensee (DE)
(74) Representative: Eisenführ, Speiser & Partner

(56) References cited:
- DE-C1- 19 618 481
- US-A- 5 159 537
- US-A- 5 162 971

## Description

The present invention relates to a one-piece shielding hood with one or more pins for attaching a second device, a blank of a supple material and an arrangement of a first and a second device.

Shielding hoods, which in the art are also called shielding caps or shielding cans, are used for reducing electromagnetic interference (EMI) between external electromagnetic radiation and electromagnetic radiation originating form a device. The device or module to be shielded is usually part of an application device, such as a printed circuit board, which may carry integrated circuits, active and passive electronic devices etc. A non-restrictive example of an application device is a radio frequency (RF) module for use in machine-to-machine communication. An application device is hereinafter also referred to in short as an "application".

For reducing EMI, the shielding hood is imposed over the device or module, respectively. The shielding hood needs to be fixed to the application. In a first group of known shielding hoods, a respective shielding hood is provided in two parts, a frame part and a cover plate. The frame part is fixed to the application and is usually equipped with soldering pins for connecting the frame with the cover plate. In a second group of known shielding hoods, a respective shielding hood is made of one piece and is usually installed via screws.

German patent specification DE 196 18 481 C1 describes a metallic housing for sheathing and shielding an electronic component. The metallic housing comprises a plurality of protrusions that serves for fixing the metallic housing to a printed circuit board. Furthermore, an electric reference potential can be supplied to the metallic housing via the plurality of protrusions.

Similarly, United States patent specification US 5,159,537 describes a metallic housing for sheathing and shielding an electronic component. Also, this metallic housing comprises two protrusions with which the metallic housing can be mounted to a printed circuit board.

Another metallic housing is known from US 5,162,971. This metallic housing comprises a plurality of pins that are cut and bent out of a surface of the metallic housing, such that they extend to an interior of the metallic housing. The metallic housing serves for sheathing and shielding an electronic component. The pins bent to the interior are connected to so-called landing pads through which a reference potential is imposed to the metallic housing.

It is an object of the present invention to expand the functionality of a shielding hood. According to a first aspect of the invention that object is achieved by providing the electromagnetic shielding hood as defined in claim 1.

The one-piece shielding hood of the first aspect of the invention is adapted to sheath a first device mounted on a carrier surface in an interior of the shielding hood and to reduce electromagnetic interference between electromagnetic radiation in an exterior of the shielding hood and electromagnetic radiation in the interior of the shielding hood. Also, the shielding hood is adapted for mounting on the carrier surface.

The shielding hood comprises one or more pins for attaching a second device to a side of the shielding hood facing to the exterior of the shielding hood, wherein the pins are at least partially cut and bent out of the shielding hood. The invention is based on the recognition that the use of screws for attaching modules to existing applications, such as a printed circuit board, is unpractical: For each screw, a respective thread has to be provided. Also, the screwing process is disadvantageous since it either requires manual labour or a complex processing machine.

The one-piece shielding hood of the present invention is not only adapted to reduce electromagnetic interference between electromagnetic radiation in an exterior of the shielding hood and electromagnetic radiation in the interior of the shielding hood, but comprises one or more pins for attaching a second device to a side of the shielding hood facing to the exterior of the shielding hood, wherein the pins are at least partially cut and bent out of the shielding hood. This results in a low complex set-up of the shielding hood that can further serve as a receiving element for attaching a second device to the carrier surface. Therefore, no screws and threads or equivalent fastening means, respectively, have to be provided.

Due to its low complex set-up, the one-piece shielding hood of the present invention can be manufactured with means of a pressing and bending machine. Since the shielding hood is formed integrally, no grooves, slots, plug connections or the like have to be provided for connecting multiple hood parts with each other to form the hood.

Preferentially, the shape of the shielding hood is adapted to the geometric facts of the first device to be shielded. The first device to be shielded is in most cases an electronic device such as an integrated circuit (IC), an electronic chip, a sensor but also a passive electronic device like a coil, capacitor or resistor. It shall be understood that within the scope of this application, the wording sheath also comprises the meaning of the wording impose.

The shape and arrangement of the pins is advantageously matched to the geometrical facts of the second device to be attached to the shielding hood. In one embodiment, the pins are arranged for penetrating holes of a surface of the second device, thus attaching it to the shielding hood. In another embodiment, the pins are arranged to be fixed upon a surface of the second device without penetrating it. Therefore, the second device can be attached to the shielding hood within the scope of surface-mount technology (SMT).

A further advantage of the shielding hood of the present invention is that the pins may be positioned anywhere on the shielding hood, since the shielding hood is formed integrally and no further parts of the shielding hood, such as a separate cover plate, have to be taken into account. The position of the pins is preferentially matched to the geometrical facts of the second device to be attached to the shielding hood.

In the following, embodiments of the one-piece shielding hood of the first aspect of the invention are described. The combination of these embodiments can lead to further examples of carrying out the invention, as far as the embodiments are not explicitly described as being alternative to each other.

In one embodiment, the shielding hood of the present invention sheathes an electronic device as the first device mounted on a carrier surface of a first printed circuit board. A second device or module is mounted on a second printed circuit board and attached to the shielding hood via the pins of the shielding hood. Therefore, the one-piece shielding hood simultaneously serves as an EMI-reduction and connection means.

For improving the shielding capabilities of the shielding hood, the shielding hood is preferentially connected to ground or mass, respectively, of the carrier surface.

In a preferred embodiment, an upper surface of the shielding hood is of rectangular shape. However, in other embodiments, the upper surface of the shielding hood exhibits different shapes, such as a triangular shape, a circular shape, a trapezoidal shape, a substantially rectangular shape with bevelled/rounded corners or further derivable shapes.

The shielding hood is preferably made of a metallic material. In yet a preferred embodiment, the shielding hood is made of solderable material. This has the advantage that the second device can be soldered to the shielding hood. In one embodiment, the pins of the shielding hood penetrate holes of a surface of the second device to be attached to the shielding hood and are soldered, for instance, to a soldering eye or to a ground plate or to a mass plate of the second device. In another embodiment, the pins are soldered to soldering boards of the second device, thereby attaching it to the shielding hood within the scope of SMT.

Preferentially, the solderable material is a copper-nickel-alloy or nickel silver. However, in other embodiments other solderable materials, such as German silver, alpaca, further common metallic materials which are employed in the housing and shielding technology, gold, gold alloys, silver or silver-alloys are used.

The shielding hood comprises a frame part and a cover part. This set-up has the advantage of standard shape that can be employed in many applications and enjoys a large scope of design possibilities for sheathing various devices. In a preferred embodiment, the lower edges of the frame part of the shielding hood are soldered and/or glued to the carrier surface. In another embodiment, the frame part is screwed or bonded to the carrier surface, or fixed otherwise to the carrier surface. For reasons of a compact design, the frame part and cover part of the shielding hood are preferentially arranged perpendicular to each other.

Within the scope of this invention, the wording perpendicular refers to an angle of 90° or approximately 90°. However, angles that deviate slightly from 90°, for instance by an amount in between 1° and 20°, shall still be considered as being perpendicular. In the same context, the wording parallel refers to an angle of 0° or approximately 0°. However, angles that deviate slightly from 0°, for instance by an amount in between 1° to 20°, shall still be considered as being parallel.

In a preferred embodiment, at least one pin is cut and bent out only of the frame part of the shielding hood. In this embodiment, the pin is consequently located at a transition of the frame part to the cover part. Therefore, if a plurality of pins are cut and bent out only of the frame part of the shielding hood and are located along the transition of the frame part to the cover part, they define a seat-engaging area for the second device to be attached to the shielding hood having a circumference approximately identical to the circumference of the cover part. Therefore, an attachment surface of the second device may be as large or larger than the area of the cover part of the shielding hood. Therefore, this embodiment is particularly preferred, if a large second device is to be attached.

In another preferred embodiment, at least one pin is cut and bent out only of the cover part of the shielding hood. Proceeding on the aforesaid, this embodiment is particularly preferred, if a small second device is to be attached to the shielding hood.

In one embodiment, at least one pin of the shielding hood is bent out of the cover and/or frame part such that it is arranged substantially parallel to the cover part of the shielding hood. However, depending on the geometric characteristics of the second device, the pins of the shielding hood may be arranged in any angle to the cover part.

In yet a preferred embodiment, at least one pin of the shielding hood is bent out of the cover and/or frame part such that it is arranged substantially perpendicular to the cover part of the shielding hood. Therefore, the pin is arranged for penetrating holes of a surface of the second device to be attached to the shielding hood. Many devices require that kind of attachment.

It is particularly preferred that the at least one pin has the shape of a capital letter "T", wherein the upper edge of the horizontal bar of the "T" forms a bending edge along which the at least one pin is bent out of the shielding hood or the shape of a capital letter "L", wherein the lower edge of the horizontal bar of the "L" forms the bending edge along which the at least one pin is bent out of the shielding hood.

Preferentially, the vertical bar of the "T"-shaped pin or, respectively, of the "L" shaped pin penetrates a hole of a surface of the second device, wherein the horizontal bar of the "T"-shaped pin or, respectively, of the "L" shaped pin does not penetrate the hole. Therefore, the second device is attached in a predefined distance to the shielding hood. Preferentially, an overlapping part of the vertical bar of the "T"-shaped pin or, respectively, of the "L" shaped pin that has completely passed the hole is soldered, for instance, to a soldering eye or to a ground plate or a mass plate of the second device. In one embodiment, the predefined distance measures between 0,1 mm...10 mm, preferentially between 0,1 mm and 5 mm.

In a further embodiment, at least one pin of the shielding hood is bent out of the cover and/or frame part such that it defines a seat-engaging surface being parallel to the cover part of the shielding hood. This has the advantage that the second device can be attached to the shielding hood within the scope of SMT. The pin is, for instance, arranged such that the seat-engaging surface is in one plane with the cover part of the shielding hood or such that the seat-engaging surface has a certain distance to the cover part of the shielding hood. Within the scope of this application, the pins of this embodiment of the shielding hood are also to referred to as SMT-pins. It shall be understood that in fact the shielding hood is "surface-mounted" on the second device via the pin. Preferentially, the pin is soldered to soldering boards of the second device, thereby attaching it to the shielding hood.

In a preferred embodiment of the shielding hood allowing an attachment of the second device within the scope of SMT, at least one pin comprises
- a first part with a second bending edge and a third bending edge, the first part being bent out of the shielding hood along the second bending edge such that it is arranged angularly to the cover part; and
- a second part adjoining the first part in longitudinal direction, the second part being bent along the third bending edge such that it is arranged in distance and in parallel to the cover part.

This embodiment is advantageous since the second device can be attached in a predefined distance, for instance in a predefined distance that measures 0,1 mm...10 mm, preferentially 0,1 mm...5 mm to the shielding hood. Preferentially, the second part of the pin is soldered to a soldering board of the second device.

The first device to be shielded is usually of a rectangular shape. Therefore, the shielding hood is preferentially also of rectangular shape and at least one pin is arranged centered at a side of the rectangular shaped shielding hood.

In another preferred embodiment, shielding hood is of rectangular shape and at least one pin is arranged at a corner of the rectangular shaped shielding hood.

However, the pin or pins of the shielding hood can be positioned anywhere on the shielding hood, such that it/they advantageously matches/match to the geometric characteristics and demands of the second device.

In a particularly preferred embodiment of the one-piece shielding hood, at least one pin is chamfered. In this embodiment, attaching the second device to the one-piece shielding hood is facilitated, as the chamfered pin can more easily be inserted into holes of the second device.

In another preferred embodiment of the one-piece shielding hood, at least one bar is partly cut and bent out of the frame part or, respectively, out of the cover part, the bar being adapted for serving as a gripping contact. This has the advantage that the shielding hood can be gripped via the bar during the manufacturing process or during the installation of the shielding hood to the carrier surface.

The one-piece shielding hood of claim 1 may be employed in any technical field where a shielding a device and/or a connecting two devices is needed.

According to a second aspect of the invention, an arrangement of a first device mounted to a carrier surface and a second device, wherein the second device is attached to the first device via a one-piece shielding hood according to the first aspect of the invention.

In one embodiment of the arrangement of the second aspect of the invention, the shielding hood of the first aspect of the present invention sheathes an electronic device, such as an integrated circuit (IC), a chip or a sensor mounted on a carrier surface of a first printed circuit board. A second device or module, for instance a second IC, is mounted on a second printed circuit board and attached to the shielding hood via the pins of the shielding hood of the first aspect of the invention. Therefore, the one-piece shielding hood serves as an EMI-reduction and connection means for a first and a second printed circuit board.

A third aspect of the invention concerns a blank of a supple material comprising pre-formed cutting and bending lines which are arranged such that when the blank is cut and bent along the pre-formed cutting and bending lines it forms a one-piece shielding hood according the first aspect of the invention. It is noted that in the context of the present invention the supple material is to be understood as a material that allows non-elastical bending or non-elastical folding in the manufacturing process of the shielding hood.

The blank of the third aspect of the invention shares the advantages of the shielding hood of the first aspect of the invention. It is preferably made of a metallic material.

It shall be understood that the one-piece shielding hood of claim 1, the arrangement of claim 14 and the blank of claim 15 have similar and/or identical preferred embodiments, in particular, as defined in the dependent claims.

It shall further be understood that a preferred embodiment of the invention can also be any combination of the dependent claims with the respective independent claim.

These and other aspects of the invention will be apparent from and explained with reference to the embodiments described hereinafter. In the following drawings:
- Fig.1: schematically shows a side view of a one-piece shielding hood according to the first aspect of the invention, wherein the pins are perpendicular to the cover part and cut and bent out of the frame part,
- Fig. 2: schematically shows a top view of a one-piece shielding hood according to the first aspect of the invention, wherein the pins are perpendicular to the cover part and cut and bent out of the frame part,
- Fig. 3: schematically shows a side view of a one-piece shielding hood according to the first aspect of the invention, wherein "T"-shaped pins are located per- pendicular to the cover part at a corner of the shielding hood and are cut and bent out of the frame part,
- Fig. 4: schematically shows a top view of a one-piece shielding hood according to the first aspect of the invention, wherein "T"-shaped pins are located per- pendicular to the cover part at a corner of the shielding hood and are cut and bent out of the frame part,
- Fig. 5: schematically shows a side view of a one-piece shielding hood according to the first aspect of the invention, wherein "T"-shaped pins are located per- pendicular to the cover part at a each side of the shielding hood and are cut and bent out of the cover part,
- Fig. 6: schematically shows a top view of a one-piece shielding hood according to the first aspect of the invention, wherein "T"-shaped pins are located per- pendicular to the cover part at a each side of the shielding hood and are cut and bent out of the cover part,
- Fig. 7: schematically shows a side view of a one-piece shielding hood according to the first aspect of the invention, wherein the SMT-pins are located parallel to the cover part at a corner of the shielding hood and are cut and bent out of the frame part,
- Fig. 8: schematically shows a top view of a one-piece shielding hood according to the first aspect of the invention, wherein the SMT-pins are located parallel to the cover part at a corner of the shielding hood and are cut and bent out of the frame part,
- Fig.9: schematically shows a side view of a one-piece shielding hood according to the first aspect of the invention, wherein the pins are chamfered and
- Fig. 10: schematically shows a top view of a one-piece shielding hood according to the first aspect of the invention, wherein the pins are chamfered.

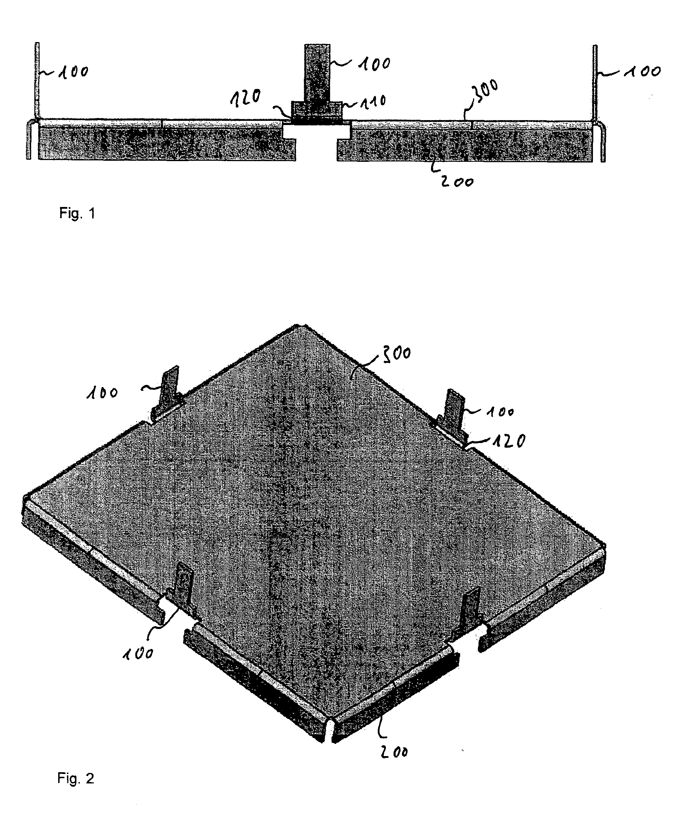

Fig. 1 schematically shows a side view of a first embodiment of the one-piece shielding hood, wherein the pins 100 are perpendicular to the cover part 300 and cut and bent out of the frame part 200. The one-piece shielding hood of Fig. 1 serves for sheathing a first device mounted on carrier surface (not shown in Fig. 1) in an interior of the shielding hood and for reducing electromagnetic interference (EMI) between electromagnetic radiation in an exterior of the shielding hood and electromagnetic radiation in the interior of the shielding hood.

The shielding hood of Fig. 1 is adapted to be mounted on the carrier surface. The pins 100 of the shielding hood serve for attaching a second device (not shown in Fig. 1) substantially parallel to the cover part 300 of the shielding hood. Due to the T-shape of the pins 100 the second device can be attached to the shielding hood such that it keeps a defined distance to the cover part 300, which is defined by the height of the horizontal bar 110 of a respective pin 100. For instance the horizontal bar 110 has a height which measures between 0,1 mm and 10 mm. Thus, one edge of the horizontal bar of the T-shaped pin forms a bending edge 120 along which the pin 100 is bent out of the shielding hood. The vertical bar of the T-shaped pin penetrates a hole of a surface of the second device, wherein the horizontal bar 110 of the T-shaped pin 100 does not penetrate the hole.

The one-piece shielding hood of Fig. 1 exhibits a low complex set up and is adapted to serve at least two purposes: reducing EMI and connecting two devices with each other, for example a carrier surface with the first device and a second carrier surface with the second device. Due to its low complex set up, the one-piece shielding hood of Fig. 1 can be manufactured with means of a pressing and bending machine. Since the shielding hood is formed integrally, no grooves, slots, plug connections or the like have to be provided for connecting multiple hood parts with each other to form the hood. The first device to be shielded is in most cases an electronic device such as an integrated circuit, an electronic chip, a sensor, a coil, a capacitor or resistor.

Fig. 2 schematically shows a top view of the first embodiment of the one-piece shielding hood depicted in Fig. 1. The frame part 200 and the cover part 300 are arranged perpendicular to each other. The pins 100 are cut and bent out of a respective center of the four-side frame part 200. The T-shaped pins 100 are supposed to penetrate a second device and to be soldered, for instance, to soldering eyes or to a ground/mass plate of the second device, thereby connecting the second device and the one-piece shielding hood.

In all embodiments, the one-piece shielding hood is preferentially made out of solderable material, such as copper-nickel-alloy.

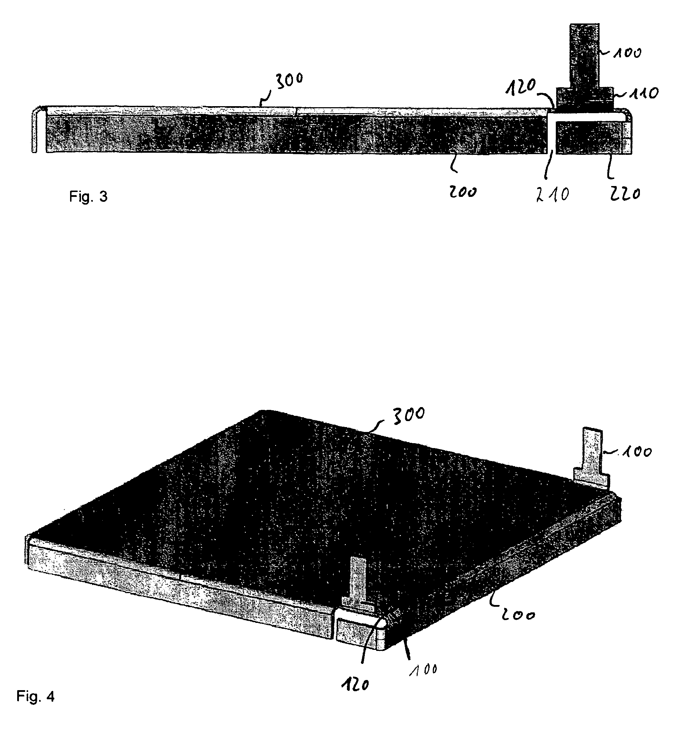

Fig. 3 schematically shows a side view of a second embodiment of a one-piece shielding hood, wherein the pins 100 are T-shaped, cut and bent out of the frame part 200 and located at a corner of the rectangular-shaped cover part 300. This embodiment has the advantage that the nick 210 left by the cut of the pin 100 in the frame part 200 can easily be covered with the overlap 220 of the frame part in arranged perpendicular to the frame part from which the pin 100 has been cut and bent out. Thereby, the reduction of EMI is increased. Fig. 4 shows a top view of the second embodiment of the one-piece shielding hood depicted in Fig. 3.

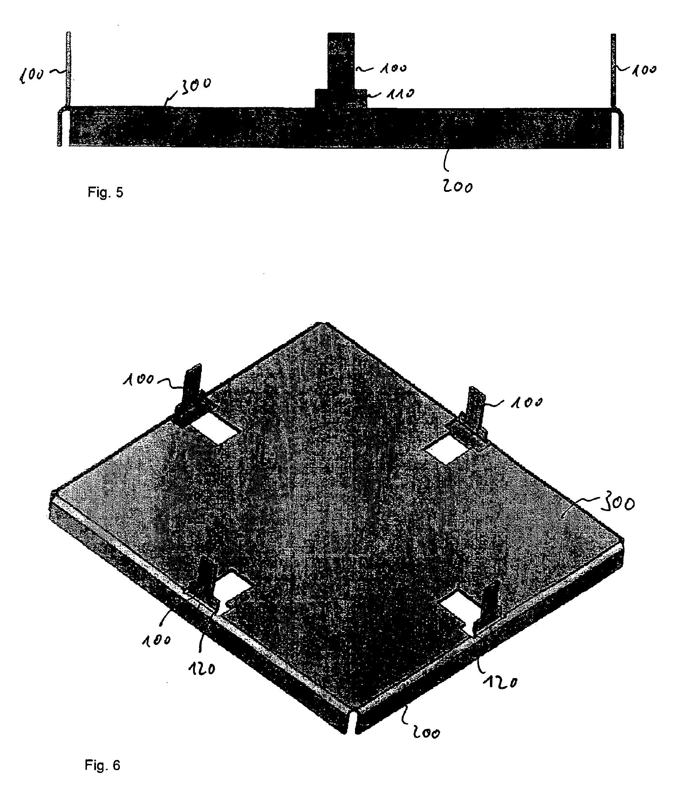

Fig. 5 schematically shows a side view of a third embodiment of the one-piece shielding hood, wherein the T-shaped pins 100 are located perpendicular to the cover part 300 at each side of the rectangular shaped shielding hood and are cut and bent out of the cover part 300. Fig. 6 shows a top view of the third embodiment of the one-piece shielding hood depicted in Fig. 5. In Fig. 5 and in Fig. 6, the pins 100 are arranged at a transition from the cover part 300 to the frame part 200. This arrangement is suitable for rather large second devices. In other embodiments, the pins 100 are cut and bent out from other positions of the cover part 300, for instance from center-near positions of the cover part.

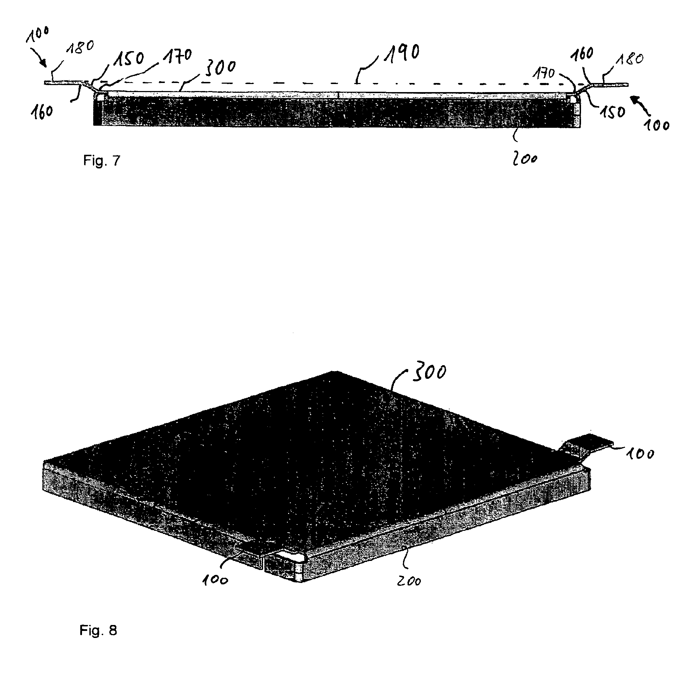

Fig. 7 schematically shows a side view of a fourth embodiment of the one-piece shielding hood, wherein the pins 100 are SMT-pins that are cut and bent out of the frame part 200 and located at a corner of the rectangular shaped shielding hood. The SMT-pins 100 define a seat-engaging surface 190, indicated by the dashed line, being substantially parallel to the cover part 300 of the shielding hood. This has the advantage that the second device (not shown in Fig. 7) can be attached to the shielding within the scope of surface mount technology (SMT). Preferentially, the pins 100 are soldered to soldering pads of the second device. A SMT-pin 100 has a first part 150 and a second part 180. The first part 150 has a second bending edge 170 and a third bending edge 160, the first part 150 being bent out of the shielding hood along the second bending edge 170 such that it is arranged angularly to the cover part 300. The second part 180 adjoins the first part 150 in longitudinal direction and is bent along the third bending edge 160 such that is arranged in distance and in parallel to the cover part 300.

Also in the fourth embodiment of the shielding hood, the second device can be attached in a predefined distance, such as 0,1 mm to 10 mm, to the shielding hood. Preferentially, the second part 180 of the SMT-pin 100 is soldered to a soldering pad of the second device. Fig. 8 schematically shows a top view of the fourth embodiment of the shielding hood depicted in Fig. 7.

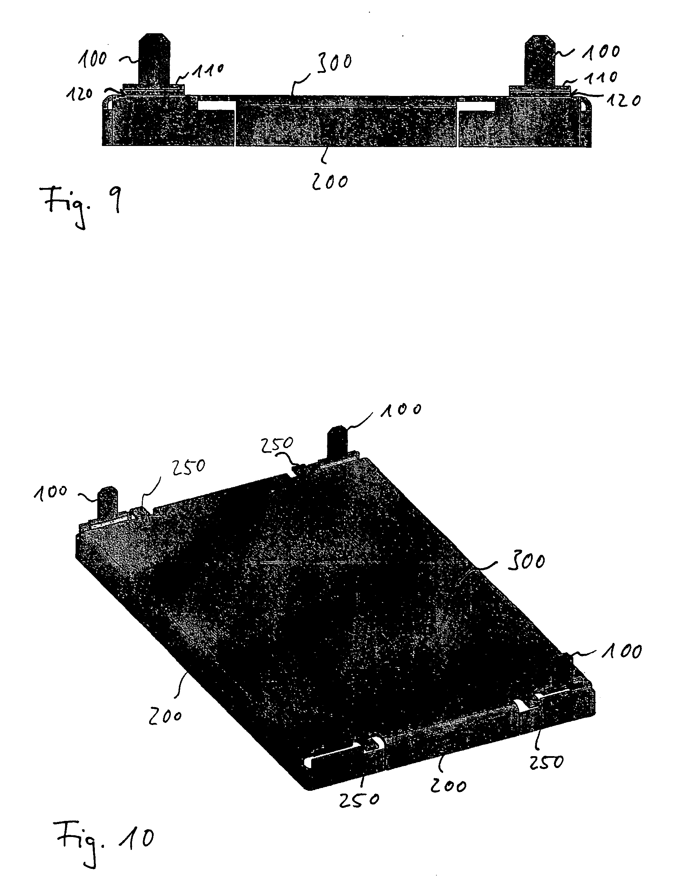

Fig. 9 schematically shows a side view of a fifth embodiment of the one-piece shielding hood according to the first aspect of the invention, wherein the pins 100 are chamfered. In this preferred embodiment, attaching the second device to the one-piece shielding hood is facilitated since the chamfered pins 100 can more easily be inserted into holes of the second device. Furthermore, not only the pins 100 are cut and bent out of the frame part 200, but also adjacently located small bars 250 that are advantageous for the manufacturing and/or the installation of the one-piece shielding hood. For instance, the one-piece shielding hood may be gripped during different phases of the manufacturing process or during the installation process. After the one-piece shielding hood has been installed on the carrier surface, an overlapping part of the bars 250 is preferentially cut off of the one-piece shielding hood, thereby rendering the embodiment depicted in Fig. 9.

Fig. 10 schematically shows a top view of the fifth embodiment of the shielding hood depicted in Fig. 9.

The present invention relates to a one-piece shielding hood with one or more pins for attaching a second device, a blank of a supple material and an arrangement of a first and a second device. The one-piece shielding hood is adapted to sheath a first device mounted on a carrier surface in an interior of the shielding hood and to reduce electromagnetic interference between electromagnetic radiation in an exterior of the shielding hood and electromagnetic radiation in the interior of the shielding hood. The shielding hood is adapted for mounting on the carrier surface. According to the invention the shielding hood further comprises one or more pins for attaching a second device to a side of the shielding hood facing to the exterior of the shielding hood, wherein the pins are at least partially cut and bent out of the shielding hood. This allows both shielding a first device of a first printed circuit board and connecting a second device to the first printed circuit board with means of single one-piece shielding hood.

## Claims

1. A one-piece shielding hood for sheathing a first device mounted on a carrier surface in an interior of the shielding hood and for reducing electromagnetic interference between electromagnetic radiation in an exterior of the shielding hood and electromagnetic radiation in the interior of the shielding hood, the shielding hood being adapted for mounting on the carrier surface and comprising:
- a frame part (200) and a cover part (300) and
- one or more pins (100) for attaching a second device above the carrier surface to a side of the cover part (300) or to a side of the frame part (200) facing to the exterior of the shielding hood, **characterised in that**
- the pins (100) are at least partially cut and bent out of a surface of the frame part (200) or out of a surface of the cover part (300), such that they extend to the exterior of the shielding hood.

2. The shielding hood of claim 1, wherein the shielding hood is made of solderable material.

3. The shielding hood of claim 2, wherein the solderable material is a copper-nickel-alloy or nickel silver.

4. The shielding hood of claim 1, wherein the frame part (200) and cover part (300) of the shielding hood are arranged perpendicular to each other.

5. The shielding hood of claim 1, wherein at least one pin (100) is cut and bent out only of the frame part (200) of the shielding hood.

6. The shielding hood of claim 1, wherein at least one pin (100) is cut and bent out only of the cover part (300) of the shielding hood.

7. The shielding hood of claim 1, wherein at least one pin (100) of the shielding hood is bent out of the cover and/or frame part such that it is arranged substantially perpendicular to the cover part (300) of the shielding hood.

8. The shielding hood of claim 1, wherein at least one pin (100) has the shape
- of a capital letter "T", wherein the upper edge of the horizontal bar (110) of the "T" forms a bending edge (120) along which the at least one pin (100) is bent out of the shielding hood or
- of a capital letter "L", wherein the lower edge of the horizontal bar of the "L" forms the bending edge along which the at least one pin is bent out of the shielding hood.

9. The shielding hood of claim 1, wherein at least one pin (100) of the shielding hood is bent out of the cover and/or frame part such that it defines a seat-engaging surface (190) being parallel to the cover part of the shielding hood.

10. The shielding hood of claim 1, wherein at least one pin (100) comprises
- a first part (150) with a second bending edge (170) and a third bending edge (160), the first part (150) being bent out of the shielding hood along the second bending edge (170) such that it is arranged angularly to the cover part (300); and
- a second part (180) adjoining the first part (150) in longitudinal direction, the second part (180) being bent along the third bending edge (160) such that it is arranged in distance and in parallel to the cover part (300).

11. The shielding hood of claim 1, wherein the shielding hood is of rectangular shape and at least one pin (100) is arranged centered at a side of the rectangular shaped shielding hood.

12. The shielding hood of claim 1, wherein the shielding hood is of rectangular shape and at least one pin (100) is arranged at a corner of the rectangular shaped shielding hood.

13. An arrangement of a first device mounted to a carrier surface and a second device, wherein the second device is attached to the first device via a one-piece shielding hood according to any of the previous claims.

14. A blank of a supple material comprising
- pre-formed cutting and bending lines which are arranged such that when the blank is cut and bent along the pre-formed cutting and bending lines it forms a one-piece shielding hood according to any of the previous claims.

## Patentansprüche

1. Einteilige Abschirmhaube zum Ummanteln einer ersten Vorrichtung, die auf einer Trägerfläche in einem Innenraum der Abschirmhaube montiert ist, und zum Reduzieren elektromagnetischer Überlagerung zwischen elektromagnetischer Strahlung in einem Außenraum der Abschirmhaube und elektromagnetischer Strahlung in dem Innenraum der Abschirmhaube, wobei die Abschirmhaube für eine Montage auf der Trägerfläche ausgelegt ist und enthält:
- einen Rahmenteil (200) und einen Abdeckteil (300), und
- einen oder mehrere Stifte (100) zum Anbringen einer zweiten Vorrichtung oberhalb der Trägerfläche an einer Seite des Abdeckteils (300) oder an einer Seite des Rahmenteils (200), die dem Außenraum der Abschirmhaube zugewandt ist,
**dadurch gekennzeichnet, dass**
- die Stifte (100) wenigstens teilweise aus einer Oberfläche des Rahmenteils (200) oder aus einer Oberfläche des Abdeckteils (300) geschnitten und herausgebogen sind, so dass sie sich zu dem Außenraum der Abschirmhaube erstrecken.

2. Abschirmhaube nach Anspruch 1, wobei die Abschirmhaube aus einem lötbaren Material gefertigt ist.

3. Abschirmhaube nach Anspruch 2, wobei das lötbare Material eine Kupfer-Nickel-Legierung oder Nickelsilber ist.

4. Abschirmhaube nach Anspruch 1, wobei der Rahmenteil (200) und der Abdeckteil (300) der Abschirmhaube senkrecht zueinander angeordnet sind.

5. Abschirmhaube nach Anspruch 1, wobei wenigstens ein Stift (100) nur aus dem Rahmenteil (200) der Abschirmhaube geschnitten und herausgebogen ist.

6. Abschirmhaube nach Anspruch 1, wobei wenigstens ein Stift (100) nur aus dem Abdeckteil (300) der Abschirmhaube geschnitten und herausgebogen ist.

7. Abschirmhaube nach Anspruch 1, wobei wenigstens ein Stift (100) der Abschirmhaube aus dem Abdeckteil und/oder dem Rahmenteil herausgebogen ist, so dass er im Wesentlichen senkrecht zu dem Abdeckteil (300) der Abschirmhaube angeordnet ist.

8. Abschirmhaube nach Anspruch 1, wobei wenigstens ein Stift (100) die Form
- eines großen Buchstaben "T" aufweist, wobei die obere Kante des horizontalen Balkens (110) des "T" eine Biegekante (120) bildet, längs der der wenigstens eine Stift (100) aus der Abschirmhaube herausgebogen ist, oder
- eines großen Buchstaben "L" aufweist, wobei die untere Kante des horizontalen Balkens des "L" die Biegekante bildet, längs der der wenigstens eine Stift (100) aus der Abschirmhaube herausgebogen ist.

9. Abschirmhaube nach Anspruch 1, wobei wenigstens ein Stift (100) der Abschirmhaube aus dem Abdeckteil und/oder dem Rahmenteil herausgebogen ist, so dass er eine Sitzeingriffsfläche (190) definiert, die zum Abdeckteil der Abschirmhaube parallel ist.

10. Abschirmhaube nach Anspruch 1, wobei wenigstens ein Stift (100) enthält:
- einen ersten Teil (150) mit einer zweiten Biegekante (170) und einer dritten Biegekante (160), wobei der erste Teil (150) längs der zweiten Biegekante (170) aus der Abschirmhaube herausgebogen ist, so dass er zu dem Abdeckteil (300) abgewinkelt angeordnet ist; und
- einen zweiten Teil (180), der in Längsrichtung an den ersten Teil (150) grenzt, wobei der zweite Teil (180) längs der dritten Biegekante (160) gebogen ist, so dass er in einem Abstand parallel zu dem Abdeckteil (300) angeordnet ist.

11. Abschirmhaube nach Anspruch 1, wobei die Abschirmhaube eine rechtwinklige Form aufweist, und wobei wenigstens ein Stift (100) zentriert an einer Seite der rechtwinklig geformten Abschirmhaube angeordnet ist.

12. Abschirmhaube nach Anspruch 1, wobei die Abschirmhaube eine rechtwinklige Form aufweist, und wobei wenigstens ein Stift (100) an einer Ecke der rechtwinklig geformten Abschirmhaube angeordnet ist.

13. Anordnung aus einer ersten Vorrichtung, die auf einer Trägerfläche montiert ist, und einer zweiten Vorrichtung, wobei die zweite Vorrichtung an der ersten Vorrichtung über eine einteilige Abschirmhaube nach einem der vorangehenden Ansprüche angebracht ist.

14. Rohling eines biegsamen Materials, enthaltend:
- vorgeformte Schnitt- und Biegelinien, die so angeordnet sind, dass der Rohling dann, wenn er längs der vorgeformten Schnitt- und Biegelinien geschnitten und gebogen wird, eine einteilige Abschirmhaube nach einem der vorangehenden Ansprüche bildet.

## Revendications

1. Hotte de protection d'un seul tenant pour envelopper un premier dispositif monté sur une surface de support à l'intérieur de la hotte de protection et pour réduire une interférence électromagnétique entre du rayonnement électromagnétique à l'extérieur de la hotte de protection et du rayonnement magnétique à l'intérieur de la hotte de protection, la hotte de protection étant conçue pour être montée sur la surface du support et comprenant :
- une partie (200) formant cadre et une partie (300) formant couvercle et
- une languette (100) ou plusieurs languettes (100) pour assujettir un deuxième dispositif au-dessus de la surface du support à un côté de la partie (300) formant couvercle ou à un côté de la partie (200) formant cadre faisant face à l'extérieur de la hotte de protection, **caractérisée en ce que**
- les languettes (100) sont découpées, au moins en partie, et courbées hors d'une surface de la partie (200) formant cadre ou d'une surface de la partie (300) formant couvercle, de manière à s'étendre à l'extérieur de la hotte de protection.

2. Hotte de protection suivant la revendication 1, dans laquelle la hotte de protection est en un matériau soudable.

3. Hotte de protection suivant la revendication 2, dans laquelle le matériau soudable est un alliage de cuivre et de nickel ou du nickel argent.

4. Hotte de protection suivant la revendication 1, dans laquelle la partie (200) formant cadre et la partie (300) formant couvercle de la hotte de protection sont disposées perpendiculairement l'une à l'autre.

5. Hotte de protection suivant la revendication 1, dans laquelle au moins une languette (100) est découpée et courbée hors de seulement la partie (200) formant cadre de la hotte de protection.

6. Hotte de protection suivant la revendication 1, dans laquelle au moins une languette (100) est découpée et courbée hors de seulement la partie (300) formant couvercle de la hotte de protection.

7. Hotte de protection suivant la revendication 1, dans laquelle au moins une languette (100) de la hotte de protection est courbée hors de la partie formant couvercle et/ou hors de la partie formant cadre, de manière à être sensiblement perpendiculaire à la partie (300) formant couvercle de la hotte de protection.

8. Hotte de protection suivant la revendication 1, dans laquelle au moins une languette (100) a la forme
- d'une lettre majuscule "T", dans laquelle le bord supérieur de la barrette (110) horizontale du "T" forme un bord (120) se courbant, le long duquel la au moins une languette (100) est courbée hors de la hotte de protection ou
- d'une lettre majuscule "L", dans laquelle le bord inférieur de la barrette horizontale du "L" forme le bord se courbant, le long duquel la au moins une languette est courbée hors de la hotte de protection.

9. Hotte de protection suivant la revendication 1, dans laquelle au moins une languette (100) de la hotte de protection est courbée hors de la partie formant couvercle et/ou de la partie formant cadre, de manière à définir une surface (190) de coopération d'assise parallèle à la partie formant couvercle de la hotte de protection.

10. Hotte de protection suivant la revendication 1, dans laquelle au moins une languette (100) comprend
- une première partie (150) ayant un deuxième bord (170) se courbant et un troisième bord (160) plié, la première partie (150) étant courbée hors de la hotte de protection le long du deuxième bord (170) plié, de manière à faire un angle avec la partie (300) formant couvercle; et
- une deuxième partie (180) adjointe à la première partie (150) dans une direction longitudinale, la deuxième partie (180) étant courbée le long du troisième bord (160) plié, de manière à être disposée à distance et parallèlement à la partie (300) formant couvercle.

11. Hotte de protection suivant la revendication 1, dans laquelle la hotte de protection est de forme rectangulaire et au moins une languette (100) est centrée sur un côté de la hotte de protection de forme rectangulaire.

12. Hotte de protection suivant la revendication 1, dans laquelle la hotte de protection est de forme rectangulaire et au moins une languette (100) est disposée en un sommet de la hotte de protection de forme rectangulaire.

13. Agencement d'un premier dispositif monté sur une surface de support et d'un deuxième dispositif, dans lequel le deuxième dispositif est assujetti au premier dispositif par une hotte de protection d'un seul tenant suivant l'une quelconque des revendications précédentes.

14. Flan en un matériau souple comprenant
- des lignes de découpe et de pliage qui sont disposées, de manière à ce que, lorsque le flan est découpé et plié le long des lignes pré-formées de découpe et de pliage, il forme une hotte de protection d'un seul tenant suivant l'une quelconque des revendications précédentes.
